(19) Europäisches Patentamt
European Patent Office
Office européen des brevets

(11) **EP 3 246 959 B1**

(12) **EUROPEAN PATENT SPECIFICATION**

(45) Date of publication and mention of the grant of the patent:
**04.03.2020 Bulletin 2020/10**

(21) Application number: **16828087.3**

(22) Date of filing: **21.07.2016**

(51) Int Cl.:
*H01L 35/12* (2006.01)    *H01L 35/16* (2006.01)
*H01L 35/18* (2006.01)    *H01L 35/02* (2006.01)
*H01L 35/34* (2006.01)

(86) International application number:
**PCT/KR2016/007964**

(87) International publication number:
**WO 2017/014583 (26.01.2017 Gazette 2017/04)**

(54) **COMPOUND SEMICONDUCTOR THERMOELECTRIC MATERIAL AND METHOD FOR MANUFACTURING SAME**

THERMOELEKTRISCHES MATERIAL FÜR EIN VERBUNDHALBLEITERBAUELEMENT UND VERFAHREN ZUR HERSTELLUNG DAVON

MATÉRIAU THERMOÉLECTRIQUE À SEMI-CONDUCTEURS COMPOSÉS ET PROCÉDÉ DE FABRICATION CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.07.2015 KR 20150103215**

(43) Date of publication of application:
**22.11.2017 Bulletin 2017/47**

(73) Proprietor: **LG Chem, Ltd.**
**Yeongdeungpo-gu**
**Seoul 07336 (KR)**

(72) Inventors:
• **KWON, O-Jong**
  **Daejeon 34122 (KR)**
• **CHOI, Hyun-Woo**
  **Daejeon 34122 (KR)**
• **LIM, Byung-Kyu**
  **Daejeon 34122 (KR)**
• **JUNG, Myung-Jin**
  **Daejeon 34122 (KR)**
• **PARK, Cheol-Hee**
  **Daejeon 34122 (KR)**

(74) Representative: **Hoffmann Eitle**
**Patent- und Rechtsanwälte PartmbB**
**Arabellastraße 30**
**81925 München (DE)**

(56) References cited:
**JP-A- S6 437 456          KR-A- 20130 015 402**
**KR-A- 20140 139 908      KR-A- 20140 139 908**
**KR-A- 20150 040 240      KR-A- 20150 040 240**
**KR-B1- 101 405 318       KR-B1- 101 405 318**
**US-A1- 2015 107 640      US-A1- 2015 107 640**
**US-B1- 6 225 548**

• **JU-HYUK YIM ET AL: "Thermoelectric Properties of Indium-Selenium Nanocomposites Prepared by Mechanical Alloying and Spark Plasma Sintering", JOURNAL OF ELECTRONIC MATERIALS, SPRINGER US, BOSTON, vol. 41, no. 6, 16 February 2012 (2012-02-16), pages 1354-1359, XP035057980, ISSN: 1543-186X, DOI: 10.1007/S11664-012-1940-X**

Remarks:
The file contains technical information submitted after the application was filed and not included in this specification

EP 3 246 959 B1

**Description**

<u>Technical Field</u>

The present disclosure relates to a compound semiconductor and a method for manufacturing the same, and more particularly, to a compound semiconductor thermoelectric material that has excellent thermoelectric conversion performance and can be usefully applied to thermoelectric conversion elements, and a method for manufacturing the same.

<u>Background Art</u>

A compound semiconductor is a semiconductor composed of two or more elements, not one element such as silicon or germanium. Various types of compound semiconductors have been developed and are currently being used in various fields of industry. Typically, compound semiconductors may be used in thermoelectric conversion elements, light emitting devices, for example, light emitting diodes or laser diodes, fuel cells, and the like.

Particularly, a compound semiconductor for use in a thermoelectric conversion element may be referred to as a thermoelectric material, and a thermoelectric material has a thermoelectric power generation or thermoelectric cooling applications. Generally, a thermoelectric conversion element includes an n-type thermoelectric material and a p-type thermoelectric material electrically connected in series and thermally connected in parallel.

Thermoelectric cooling is a form of conversion of electrical energy to thermal energy using the Peltier effect which is heat absorption and heat generation occurring between both ends of a thermoelectric module when a direct current flows through the both ends of the thermoelectric module. Thermoelectric power generation is a form of conversion of thermal energy to electrical energy using the Seebeck effect by which a thermoelectromotive force is generated when a temperature difference is formed between both ends of a thermoelectric module.

An important characteristic factor to be considered for compound semiconductor thermoelectric material is

$$ZT = \frac{S^2 \sigma T}{\kappa}$$

dimensionless figure of merit ZT, defined as $\quad$ · Here, S denotes Seebeck coefficient, $\sigma$ denotes electrical conductivity, T denotes absolute temperature, and $\kappa$ denotes thermal conductivity. As compound semiconductors having higher ZT value are applied, efficiency of thermoelectric conversion elements is further improved.

Until now, many types of compound semiconductors have been proposed as thermoelectric material, but the demand for higher ZT value is continuously growing. To increase the ZT value in order to obtain good thermoelectric conversion performance, high Seebeck coefficient and electrical conductivity and low thermal conductivity is the most effective. It is known that scattering of phonons responsible for thermal conduction is one effective means to reduce thermal conductivity, and thermoelectric materials in which nm scale fine particles are dispersed for phonon scattering have been developed. In compound semiconductors, the mean free path (MFP) of phonons is ∼ 100nm in size, and the average MFP of carriers is a few nm in size. It has been known, theoretically, if a few tens of nm scale fine particles are uniformly dispersed in a compound semiconductor, it is possible to selectively scatter only phonons.

However, in most cases, dispersion of nm scale fine particles for phonon scattering is effective in reducing lattice thermal conductivity, but tends to greatly reduce electrical conductivity. In addition, the manufacture of this thermoelectric material needs to use a high-cost process for manufacturing and dispersing nm scale fine particles, which is not suitable for mass production. KR 101 405 318 B1 describes bismuth telluride - indium selenide nanocomposite materials. US 6 225 548 B1 discloses a thermoelectric semiconductor compound comprising a matrix and particles dispersed in the matrix.

Therefore, there is a need for a compound semiconductor thermoelectric material having sufficiently high ZT value by reducing thermal conductivity while not reducing electrical conductivity and an economical method for manufacturing the same

<u>DISCLOSURE</u>

<u>Technical Problem</u>

Accordingly, the present disclosure is designed to solve the problem such as those above, and therefore, the present disclosure is directed to providing a compound semiconductor thermoelectric material having good ZT value with no reduced electrical conductivity and consequential excellent thermoelectric conversion performance and a method for manufacturing the same, and a thermoelectric module or a thermoelectric power generator and a thermoelectric cooler using the same.

Technical Solution

To achieve the object, a compound semiconductor thermoelectric material according to the present disclosure includes an n-type compound semiconductor matrix; and n-type particles dispersed in the matrix, wherein the n-type particles are a compound semiconductor different from the matrix, and have an average particle size of $1\mu$m to $100\mu$m.

Here, the n-type particles may be present in an amount of between 0.1 wt% and 1.0 wt% per the total weight of the compound semiconductor thermoelectric material.

Furthermore, the n-type particles may be disposed in a grain boundary or grains of the matrix.

Furthermore, the n-type particles may have electrical conductivity of 10 S/cm or more.

Furthermore, electron affinity of the n-type particles may be similar to or lower than electron affinity of the matrix by 0.5eV or less.

Furthermore, the n-type particles may exist as a stable secondary phase in the matrix.

The matrix is Bi-Te system or Bi-Te-Se system. Furthermore, the n-type particles are InSb or InSb:Se (representing InSb with Se doping). The matrix may further include at least one of Cu, Zn and I.

The n-type particles may induce electrical conductivity improvement by modulation doping, or Seebeck coefficient improvement by majority carrier filtering, or bipolar thermal conductivity reduction by minor carrier filtering.

To achieve the object, a thermoelectric conversion module according to the present disclosure may include the compound semiconductor thermoelectric material according to the present disclosure as an n-type element.

To achieve the object, a thermoelectric power generator and a thermoelectric cooler according to the present disclosure may each include the compound semiconductor thermoelectric material according to the present disclosure.

Furthermore, to achieve the object, a method for manufacturing a compound semiconductor thermoelectric material may include preparing an n-type compound semiconductor matrix raw material, adding n-type particles to the n-type compound semiconductor matrix raw material, wherein the n-type particles are a compound semiconductor different from the matrix and have an average particle size of between $1\mu$m and $100\mu$m, and pressure sintering.

In a preferred embodiment, the preparing of the n-type compound semiconductor matrix raw material includes forming a mixture including Bi, Te and Se, and thermally treating the mixture to form a synthesized product. Here, the forming of the synthesized product may be performed under a temperature condition of between 350°C and 450 °C and a time condition of between 10 hours and 15 hours. Furthermore, the forming of the synthesized product may be performed by a solid phase reaction process.

Furthermore, the adding of the n-type particles may be performed by a process that adds the n-type particles in powder form to the raw material in powder form.

Furthermore, the pressure sintering may be performed by a spark plasma sintering process.

Furthermore, the pressure sintering may be performed under a pressure condition of between 30 MPa and 60 MPa and a temperature condition of between 350°C and 450 °C.

Advantageous Effects

According to the present disclosure, $\mu$m scale compound semiconductor n-type particles capable of scattering phonons are added to the n-type compound semiconductor matrix, in which the n-type particles are a compound semiconductor different from the matrix, thereby effectively reducing thermal conductivity while not reducing electrical conductivity. Accordingly, it is possible to provide a compound semiconductor thermoelectric material having increased ZT value.

Particularly, because the compound semiconductor thermoelectric material according to an aspect of the present disclosure has improved ZT value, it achieves high efficiency thermoelectric cooling when used in a thermoelectric cooler.

Moreover, according to an aspect of the present disclosure, because of having high ZT value in the temperature range of from room temperature to 200 °C without electrical conductivity reduction, it is possible to provide a compound semiconductor thermoelectric material suitable to use at relatively intermediate and low temperatures.

Additionally, according to the manufacturing method of the present disclosure, it is possible to produce good thermoelectric materials in a large amount at a low cost by a simple process of adding $\mu$m scale compound semiconductor different from the matrix in powder form without a high-cost process of manufacturing and adding nm scale fine particles.

BRIEF DESCRIPTION OF THE DRAWINGS

The accompanying drawings illustrate a preferred embodiment of the present disclosure and together with the following detailed description, serve to provide further understanding of the technical aspects of the present disclosure, and thus, the present disclosure is not construed as being limited to the drawings.

FIG. 1 schematically shows the microstructure of a compound semiconductor thermoelectric material according to an embodiment of the present disclosure.

FIG. 2 is a flowchart schematically showing a method for manufacturing a compound semiconductor thermoelectric material according to an embodiment of the present disclosure.

FIGS. 3 to 5 are graphs showing the comparison of electrical conductivity, Seebeck coefficient, thermal conductivity, lattice thermal conductivity, and ZT value in examples and comparative examples of the present disclosure.

FIGS. 6 to 8 are photographic images of the microstructure of a compound semiconductor thermoelectric material according to embodiments of the present disclosure.

DETAILED DESCRIPTION

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the embodiments stated herein and illustrations shown in the drawings are just a preferable example of the present disclosure and do not represent all the technical aspects of the present disclosure, so it should be understood that there may be various equivalents and modifications for alternative embodiments at the time the application is filed.

These and other objects and advantages of the present disclosure can be understood from the following description and will become more fully apparent from the embodiments of the present disclosure. Furthermore, it will be easily understood that the objects and advantages of the present disclosure may be realized by the means set forth in the appended claims and combinations thereof.

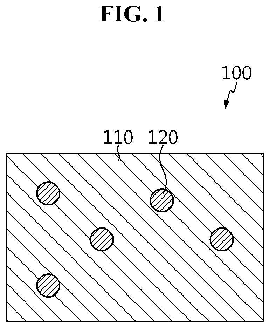

FIG. 1 schematically shows the microstructure of a compound semiconductor thermoelectric material according to an embodiment of the present disclosure.

Referring to FIG. 1, the compound semiconductor thermoelectric material 100 according to an embodiment of the present disclosure includes an n-type compound semiconductor matrix 110 and compound semiconductor n-type particles 120 dispersed in the matrix 110, wherein the n-type particles 120 are a compound semiconductor different from the matrix 110. The n-type compound semiconductor matrix 110 is a collection of grains integrated by sintering. The n-type particles 120 exist in the grains. Furthermore, the n-type particles 120 may exist in the grain boundary.

The matrix 110 is a Bi-Te system (Bi-Te-Se system). Among them, Bi-Te-Se system is desirable. Among currently available thermoelectric materials, Bi-Te-Se system has intrinsic good thermoelectric conversion performance in the low temperature range of room temperature (about 20 °C) ~ 200 °C, and accordingly, high ZT value is expected.

Particularly, Bi-Te-Se system compound further including at least one of Cu, Zn and I may be used for the matrix 110. The added Cu, Zn and I may substitute part of Bi, Te, Sb in typical n-type Bi-Te system intermetallic compound such as $Bi_2(Te, Se)_3$. The term "system" as used herein includes all compounds in which some elements are substituted by other elements.

In Bi-Te system, $(Bi, Sb)_2Te_3$ is p-type and $Bi_2(Te, Se)_3$ is n-type. As described above, n-type may be obtained with varying ingredients or their proportions, but to efficiently allow the intermetallic compound to be an n-type semiconductor, n-type dopants may be added. By adjusting the dopant content, carrier concentration in the matrix 110 can be adjusted, and as a result, the intrinsic ZT value can be increased.

The n-type particles 120 are InSb or InSb:Se. Furthermore, dopants may be added to the compound semiconductor to efficiently make an n-type semiconductor. The dopant may be S, Se, Te, and Si.

In the present disclosure, the n-type particles 120 have an average particle size of between $1\mu m$ and $100\mu m$.

As described above, in addition to the n-type compound semiconductor matrix 110 composed of a plurality of grains, the compound semiconductor thermoelectric material 100 according to the present disclosure includes the n-type particles 120 different from the n-type compound semiconductor matrix 110 having an average particle size of between $1\mu m$ and $100\mu m$ in the grain boundary or the grains of the n-type compound semiconductor matrix 110, i.e., in either the grain boundary or the grains or both.

For example, according to the configuration of the present disclosure, the $\mu m$ scale compound different from the matrix (including InSb) is present with a secondary phase in the matrix such as n-type Bi-Te-Sb system.

Phonons having the mean free path (MFP) of various distribution are present in the thermoelectric material. The added $\mu m$ scale n-type particles 120 effectively scatter phonons having MFP of similar length.

The greatest feature of the n-type particles 120 added in the present disclosure is to minimize electrical conductivity reduction caused by the addition (minimizing the carrier scattering effect). Generally, the addition of the secondary phase simultaneously scatters phonons and carriers. Aside from the present disclosure, a method for selectively reducing phonons alone uses technique to form a secondary phase of a few tens of nm size. Each of carriers and phonons has an average MFP of ~100nm and ~10nm, and it is known that a secondary phase of intermediate size can selectively reduce phonons alone.

However, the inventors found out that through addition of the n-type particles 120 of $\mu$m scale, thermal conductivity reduces to the level that is almost equal to the conventional nm scale phonon scatter effect, and when a compound semiconductor different from the matrix is used, there is no electrical conductivity reduction. As a result of effectively scattering phonons of $\mu$m scale according to the present disclosure, it is possible to increase the lattice thermal conductivity reduction effect, and improve the ZT value.

The n-type particles 120 added preferably have the following characteristics to minimize the electrical conductivity reduction effect in the matrix 110.

The n-type particles 120 may have electrical conductivity of 10 S/cm or more.

The electron affinity of the n-type particles 120 may be similar to or lower than the electron affinity of the matrix 110 by 0.5eV or less.

Furthermore, the n-type particles 120 may be present with a stable secondary phase in the matrix 110.

The n-type particles 120 may induce electrical conductivity improvement by modulation doping, Seebeck coefficient improvement by majority carrier filtering, or bipolar thermal conductivity reduction by minor carrier filtering according to the properties.

When the carrier concentration of the n-type particles 120 is high (namely, an energy difference the Fermi energy level and conduction band of the n-type particles is smaller than an energy difference between the Fermi energy level and conduction band of the matrix) at the interface between the n-type particles 120 and the matrix 110, the power factor ($S^2\sigma$) is improved by modulation doping.

Furthermore, when a weak schottky junction is formed at the interface between the n-type particles and the matrix material 100, the power factor ($S^2\sigma$) is improved by majority carrier filtering, and when the valance band of the n-type particles 120 is lower than the valance band of the matrix material 100 by at least 4-5$k_B$T, the power factor ($S^2\sigma$) is improved by minor carrier filtering.

That is, the present disclosure reduces the lattice thermal conductivity by interference scattering of phonons. Secondly, Seebeck coefficient may be increased by the majority carrier filtering effect (generally, low energy electron/hole is scattered, and Seebeck coefficient is increased), and thirdly, electrical conductivity may be increased by the modulation doping effect. Fourthly, bipolar thermal conductivity may be reduced by the minor carrier filtering effect.

As described above, according to the present disclosure, as the lattice thermal conductivity is reduced without electrical conductivity reduction, the ZT value can be improved, and according to the type of the n-type particles added and the n-type matrix material, electrical conductivity increase, or Seebeck coefficient increase, or bipolar thermal conductivity reduction can be achieved, and thus, further increase in ZT value can be achieved. Therefore, according to this aspect of the present disclosure, a compound semiconductor thermoelectric material suitably applied to high output power generation and high efficiency cooling module can be provided.

The following Table 1 shows material examples suitable for the n-type compound semiconductor matrix 110 and the n-type particles 120 different from the matrix 110 according to the present disclosure, and band gap and electron affinity.

Table 1

| Compound semiconductor | Dopant | Band gap | Electron affinity |
|---|---|---|---|
| InAs | S, Se, Te, etc | 0.354 eV | 4.9 eV |
| InSb | Te, Se, S, Si, etc. | 0.17 eV | 4.59 ev |
| In$_4$Se$_{2.35}$ | n | ~0.6 eV | 4.9 eV |
| Ag$_2$Se | n | 0.15 eV | 4.9 eV |
| N-type Bi$_2$Te$_3$ | | 0.14-0.3 eV | 4.125-4.525 eV |

The n-type particles 120 may be present in an amount of between 0.1wt% and 1.0wt% per the total weight of the compound semiconductor thermoelectric material. Particularly, the n-type particles 120 may be present in an amount of between 0.3 wt% and 0.9 wt% per the total weight of the compound semiconductor thermoelectric material. For example, the n-type particles 120 may be present in an amount of 0.5 wt% per the total weight of the compound semiconductor thermoelectric material. Within the addition range of the n-type particles 120, the thermoelectric conversion properties of the compound semiconductor thermoelectric material according to the present disclosure will be better.

According to the configuration of the present disclosure, an n-type thermoelectric material for intermediate and low temperatures having improved ZT value can be obtained.

As mentioned previously, it was known in the past that only nm scale is effective for phonon scattering, and fine particles of this size were used as phonon scatter particles, and phonon scatter particles of this size are effective in reducing thermal conductivity, but their problem is electrical conductivity reduction. Furthermore, the fine particles include, for example, $SiO_2$, $Al_2O_3$, $TiO_2$, $Bi_2O_3$, $ZrO_2$, $B_4C$, $SiC$, $Si_3N_4$, and most of them are a material that cannot contribute to the thermoelectric conversion performance of the thermoelectric material.

The proposed $\mu$m scale n-type particles different from the matrix have an excellent effect in reducing thermal conductivity and no electrical conductivity reduction problem by scattering phonons having MFP of $\mu$m level regarded as having no big effect in the past. Furthermore, the n-type particles of the present disclosure per se are phonon scatter particles, and are a compound semiconductor that can contribute to the thermoelectric conversion performance of the thermoelectric material, and thus, they are different from conventional fine particles. In addition, they provide economic efficiency because they can be manufactured using a simple low-cost process such as powder mixing without a traditional high-cost process such as solution dispersion and powder coating as described below.

The compound semiconductor thermoelectric material according to the present disclosure may be applied to a thermoelectric conversion module. That is, the thermoelectric conversion module according to the present disclosure may include the compound semiconductor thermoelectric material according to the present disclosure. The thermoelectric conversion module includes a thermoelectric element made of a thermoelectric material, an electrode, and a substrate, and the compound semiconductor thermoelectric material according to the present disclosure may be used as a material of a thermoelectric element. Particularly, the thermoelectric element of the thermoelectric conversion module may include an n-type element made of an n-type material and a p-type element made of a p-type material, and the compound semiconductor thermoelectric material according to the present disclosure may be included in the n-type element.

The compound semiconductor thermoelectric material according to the present disclosure may be applied to a thermoelectric power generator. That is, the thermoelectric power generator according to the present disclosure may include the compound semiconductor thermoelectric material according to the present disclosure. In this instance, the compound semiconductor thermoelectric material according to the present disclosure may be included as an n-type material in the thermoelectric conversion module of the thermoelectric power generator. Particularly, because the compound semiconductor thermoelectric material according to the present disclosure has a high power factor, the thermoelectric power generator using the same according to the present disclosure may have improved power output as compared to conventional device.

Furthermore, the compound semiconductor thermoelectric material according to the present disclosure may be applied to a thermoelectric cooler. That is, the thermoelectric cooler according to the present disclosure includes the compound semiconductor thermoelectric material according to the present disclosure. In this instance, the compound semiconductor thermoelectric material according to the present disclosure may be included as an n-type material in the thermoelectric conversion module of the thermoelectric cooler. Particularly, because the compound semiconductor thermoelectric material according to the present disclosure has a high ZT value, the thermoelectric cooler using the same according to the present disclosure may have improved cooling efficiency as compared to conventional device.

Furthermore, the compound semiconductor thermoelectric material according to the present disclosure may be applied to a bulk thermoelectric conversion material. That is, the bulk thermoelectric material according to the present disclosure includes the compound semiconductor thermoelectric material.

The compound semiconductor thermoelectric material according to the present disclosure may be manufactured by the following manufacturing method.

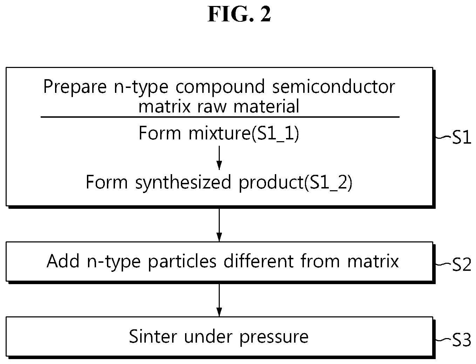

FIG. 2 is a flowchart schematically showing a method for manufacturing a compound semiconductor thermoelectric material according to an embodiment of the present disclosure.

As shown in FIG. 2, the method for manufacturing a compound semiconductor thermoelectric material according to the present disclosure includes the steps of preparing n-type compound semiconductor matrix raw materials (S1), adding n-type particles different from the matrix (S2), and pressure sintering (S3).

Particularly, when the matrix is Bi-Te-Se system, the method may include the steps of forming a mixture (S1_1), and forming a synthesized product (S1_2).

The step of forming a mixture (S1_1) is a step in which raw materials Bi, Te and Se are mixed to form a mixture. Particularly, in the step S1_1, Bi, Te and Se are weighed to make desired ingredient proportions and mixed to form a mixture.

Here, in the step S1_1, each raw material may be mixed in the form of powder. For example, the step S1_1 may be performed by grinding, hand-milling, and pelletizing raw materials Bi, Te and Se shots. However, the present disclosure is not limited to the exemplary mixing process.

The step of forming a synthesized product (S1_2) is a step in which the mixture formed in the step S1_1 is thermally treated to form a synthesized product, for example, $Bi_2Te_xSe_{a-x}$ (2.5<x<3.0, 3.0≤a<3.5). That is, the step S1_2 causes each element in the mixture to react with each other to form Bi-Te-Se system powder, for example, $Bi_2Te_{2.68}Se_{0.32}$ powder.

Here, the step S1_2 may be performed in the temperature range of between 350°C and 450 °C for 10 hours to 15 hours. For example, in the step S1_2, the pelletized raw materials are put in a tube furnace and maintained at 400 °C for 12 hours to cause each raw material to react with each other.

The thermal treatment in the step S1_2 may be performed by one method of a method using an ampoule, an arc melting method, solid phase reaction, a metal flux method, a Bridgeman method, an optical floating zone method, a vapor transport method, and a mechanical alloying method. The method using an ampoule puts raw material elements at a certain ratio in a quartz tube or an ampoule made of metal, which is sealed under vacuum, and performs thermal treatment. The arc melting method is a method including the steps of putting raw material elements in a chamber at a certain ratio, and melting the raw material elements with spark arc in inert gas atmosphere to form a sample. The SSR is a method including the steps of mixing raw material powder of a certain ratio, hardening, and performing thermal treatment, or performing thermal treatment of mixed powder, processing, and sintering. The metal flux method is a method including the steps of putting raw material elements of certain proportions and an atmosphere forming element for growing the raw material elements well at high temperature in a furnace, and performing thermal treatment at high temperature to grow crystals. The Bridgeman method is a method which puts raw material elements of a certain ratio in a furnace, applies high temperature heat at the end of the furnace until the raw material elements melt, and locally melts a sample with the slow movement of high temperature zone, so that the entire sample passes through the high temperature zone to grow crystals. The optical floating zone method is a method which makes a seed rod and a feed rod in the shape of a rod from raw material elements of a certain ratio, converges light from a lamp on the feed rod to locally melt a sample at high temperature, and slowly pulls up the melted portion to grow crystals. The vapor transport method is a method which puts raw material elements of a certain ratio in the lower part of a quartz tube, and heats the raw material element portion, while the upper part of the quartz tube is placed at low temperature, to evaporate the raw material elements, causing solid phase reaction at low temperature to grow crystals. The mechanical alloying method is a method which puts raw material powder and steel balls in a container made of ultra lightweight alloy and rotates to form an alloy-type thermoelectric material by mechanical impacts of the steel balls applied to the raw material powder.

Preferably, the step S1_2 may be performed by a solid phase reaction process from the exemplary processes. Even though thermoelectric materials have the same composition, the thermoelectric performance may vary depending on a reaction process between the raw materials. However, in the case of the compound semiconductor according to the present disclosure, when each raw material is allowed to react by a solid phase reaction process, the thermoelectric performance will be further improved than the other processes, for example, a melting process.

The step of adding n-type particles (S2) is a step of adding n-type particles that are different from the n-type Bi-Te-Se system material synthesized in the step S1_2 and have an average particle size of between $1\mu m$ and $100\mu m$. Here, as the n-type particles, an n-type compound semiconductor, for example, InSb or InSb:Se, may be added as described above.

In the step S2, the n-type particles may be added in an amount of between 0.1 wt% and 1.0 wt% per the total weight of the mixture including the n-type particles. For example, in the step S2, InSb or InSb:Se as n-type particles may be added in an amount of 0.5 wt% per the total weight of the mixture. In the case of the composition range, the improvement effect of thermoelectric conversion performance can be further increased by the addition of the n-type particles.

Preferably, the n-type particles added in the step S2 may be in powder form. Particularly, the step S2 may be performed by adding n-type particles in powder form to the synthesized product in powder form. For example, the step S2 may be performed by a mixing process that adds InSb or InSb:Se powder to $Bi_2Te_{2.68}Se_{0.32}$ powder. In the case of this embodiment, melting of raw materials or other complex process is not performed, resulting in a simple process.

The pressure sintering step (S3) is a step in which the synthesized product containing the added n-type particles is sintered. The pressure sintering is necessary to integrally bulk the synthesized product in powder form and the n-type particles in powder form, and is preferably performed by hot pressing (HP) or spark plasma sintering technique. For example, the step S3 may be performed under the pressure condition of between 30MPa and 60MPa. Furthermore, the step S3 may be performed under the temperature condition of between 350°C and 450°C. Furthermore, the step S3 may be performed for 4 minutes to 10 minutes.

Preferably, the step S3 may be performed by spark plasma sintering technique. In the case of compound semiconductor, even though compound semiconductors have the same composition, the thermoelectric performance may differ depending on sintering technique, and the compound semiconductor thermoelectric material according to the present disclosure will have further improved thermoelectric performance when sintered by this spark plasma sintering technique.

The spark plasma sintering is technique that applies pressure to powder packed in a hollow tubular mold (dice) in up and down directions using two (upper and lower) pressing members (punches) in a vacuum environment (inert atmosphere), and flows a pulsed direct current in the corresponding upper and lower punches as electrodes to produce a spark plasma, so that joule heat is generated by an eddy current in the powder and the surface is activated, achieving sintering in a short time. In this case, sintering is achieved at lower temperature than earlier sintering methods, productivity is high, and grain growth in sintered products does not happen, so the microstructure becomes compact. Additionally, if grains are pulverized into fine powder to reduce thermal conductivity, electrical conductivity tends to reduce, and in this case, hot pressing or spark plasma sintering is desirable. When the grains are oriented thereby, a reduction in electrical conductivity is prevented.

When the compound semiconductor thermoelectric material according to the present disclosure is manufactured as described above, high mean power factor and ZT value can be obtained. Particularly, in the case of the compound semiconductor thermoelectric material manufactured by the manufacturing method, it may be advantageous in obtaining high mean power factor and ZT value within the temperature range of between 20 °C and 250°C.

On the other hand, the method may further include the step of pulverizing and/or grading the thermally treated compound between the step S1_2 and the step S2. Here, the mesh size of a sieve used in gradation may be 75 $\mu$m or less. According to the configuration of the embodiment, as the particle size of the compound semiconductor powder is uniform and sintering performance increases, the compound semiconductor manufactured with the increased density of the sintered product after pressure sintering may have improved electrical conductivity. Furthermore, according to this configuration of the embodiment, as the average size of grains reduces, the grain boundary scattering effect is enhanced, and the thermal conductivity of the manufactured compound semiconductor may reduce.

Using the sieve mesh size, the powder particles before sintering have an average particle size of 30 $\mu$m or less, and preferably 10 $\mu$m or less. Furthermore, to efficiently make powder particles smaller, it is desirable to perform coarse grinding before fine grinding. The coarse grinding may be performed by jaw crushers, hammers, stamp mills, rotor mills, pin mills, cutter mills, coffee mills, and mortar. After the coarse grinding, the fine grinding may be performed by rotary ball mills, vibratory ball mills, planetary ball mills, wet mills, and jet mills.

The thermoelectric conversion element according to the present disclosure may include the compound semiconductor thermoelectric material. That is, the compound semiconductor thermoelectric material according to the present disclosure may be used as a thermoelectric conversion material of a thermoelectric conversion element. Particularly, the thermoelectric conversion element according to the present disclosure may include the compound semiconductor as an n-type thermoelectric material.

The bulk thermoelectric material obtained by pressure sintering is shaped, for example, by a cutting process, to obtain a thermoelectric element. The element is integrated on an insulating substrate together with an electrode to produce a thermoelectric module. The insulating substrate includes sapphire, silicon, pyrex, and quartz substrates. The electrode material may be selected from various materials, for example, aluminum, nickel, gold and titanium, and the electrode size may be selected from various sizes. A patterning method of the electrode is not limited to a particular type and includes any common patterning method known in the art, for example, a lift-off semiconductor process, a deposition process, and photolithography.

The compound semiconductor thermoelectric material according to the present disclosure has excellent thermoelectric conversion performance because a figure of merit value of a thermoelectric conversion material or ZT value is high. Accordingly, the compound semiconductor thermoelectric material according to the present disclosure may be usefully applied to a thermoelectric conversion element in replace of a conventional thermoelectric conversion material or in addition to a conventional compound semiconductor. A thermoelectric element, a thermoelectric module, and a thermoelectric device including the compound semiconductor thermoelectric material may be, for example, a thermoelectric cooling system and a thermoelectric power generation system, and the thermoelectric cooling system includes, but is not limited to, a non-refrigerant refrigerator, a universal cooling system, for example, an air conditioner, a micro cooling system, an air conditioning system, and a waste heat power generation system. The structure and manufacturing method of the thermoelectric cooling system is well known in the art, and its detailed description is omitted herein.

Hereinafter, the examples and comparative examples will be described to provide a further detailed description of the present disclosure. Rather, the examples according to the present disclosure may be modified in many other forms, and the scope of the present disclosure shall not be construed as being limited to the following examples. The examples of the present disclosure are provided to more fully explain the present disclosure to those having ordinary knowledge in the art to which the present disclosure pertains.

<Experimental example>

Reagents Bi, Te and Se shots were prepared and grinded, and mixed using a hand-mill to produce a mixture (BTS material) of $Bi_2Te_{2.68}Se_{0.32}$ composition. Those containing added metal powder, in particular, Zn and/or Cu, to control the performance of the Bi-Te-Se system were prepared. Furthermore, the mixture was put in a quartz tube and sealed under vacuum to produce ampoules, and the ampoules were placed in a tube furnace, followed by thermal treatment at the temperature of 400 °C for 12 hours.

Pulverization/gradation was performed on powder synthesized through thermal treatment using a sieve having mesh size of 75 $\mu$m.

To manufacture InSb and InSb:Se materials that will be used as n-type particles, In, Sb and Se shots were each loaded in a quartz tube and sealed under vacuum. Se was added in an amount of 0.1 mol% relative to InSb. Melting was performed on the quartz tube in a furnace of 600 °C for 10 minutes, and air cooling followed. An ingot created by melting was pulverized into powder having 5 ~ 75 $\mu$m size distribution using an alumina bowl.

Subsequently, InSb or InSb:Se powder was added in an amount of 0.1 ~ 1.0 wt% per the total weight, mixed, pressed under 50 MPa, and sintered by an SPS process at 400 °C for 5 minutes, to obtain example samples.

Comparative example samples were prepared without an addition of n-type particles dissimilar to the present disclosure.

The composition of examples and comparative examples was summarized in the following table 2.

Table 2

| Example | Composition | Comparative example | Composition |
|---|---|---|---|
| Example 1 | 0.1wt%InSb+BTS | Comparative example 1 | $Bi_2Te_{2.68}Se_{0.32}$ (BTS) |
| Example 2 | 0.1wt%InSb:Se+BTS | Comparative example 2 | $Bi_2Te_{2.68}Se_{0.32}$+0.3wt%Cu (Cu-BTS) |
| Example 3 | 1 wt%InSb+BTS | Comparative example 3 | 0.3wt%Cu+0.3wt%Zn+$Bi_2Te_{2.68}Se_{0.32}$ (Cu/Zn-BTS) |
| Example 4 | 0.1wt%InSb+Cu-BTS | | |
| Example 5 | 0.3wt%InSb+Cu-BTS | | |
| Example 6 | 0.3wt%InSb:Se+Cu-BTS | | |
| Example 7 | 0.1wt%InSb+Cu/Zn-BTS | | |

<Measurement>

For some samples of each of examples and comparative examples obtained as above, electrical conductivity ($\sigma$) and Seebeck coefficient (S) was measured by a 2-point probe method process using ZEM-3 (Ulvac-Rico, Inc). Furthermore, the power factor ($S^2\sigma$) was calculated using the measured values. Furthermore, for the other samples of each of examples and comparative examples, thermal conductivity was measured by a laser flash method process using LFA457 (Netzsch). More specifically, after carrying out laser irradiation on one surface of the sample in pellet form, the temperature on the opposite surface was measured, thermal diffusivity was calculated, and thermal conductivity of the sample was measured by multiplying the thermal diffusivity by the density and specific heat of the sample. Furthermore, a ZT value was calculated using each measured value.

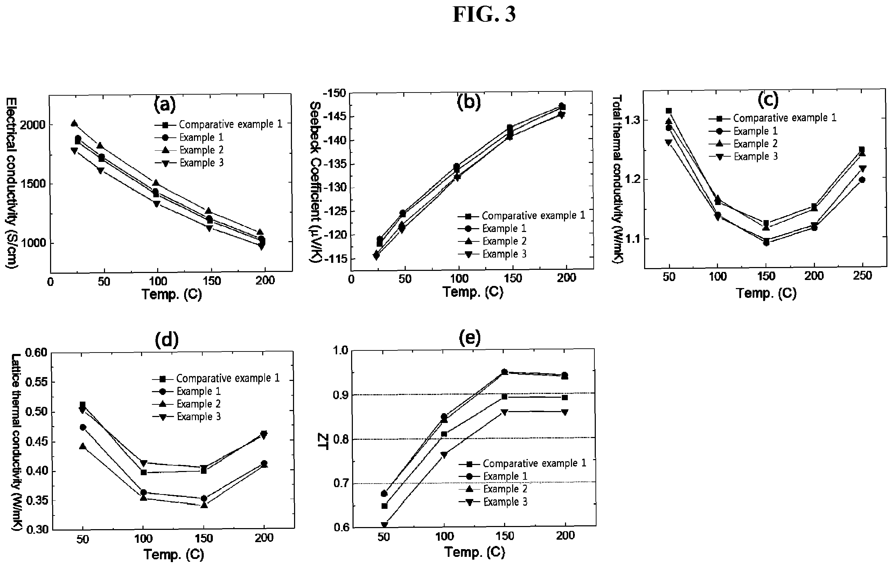

Each value was plotted as a graph at varying temperature as shown in FIGS. 3 to 5. In each drawing, (a) denotes electrical conductivity, (b) denotes Seebeck coefficient, (c) denotes thermal conductivity, (d) denotes lattice thermal conductivity, and (e) denotes ZT value.

First, FIG. 3 shows the case in which the matrix is an n-type Bi-Te material ($Bi_2Te_{2.68}Se_{0.32}$). As compared to comparative example 1, the material containing added InSb or InSb:Se as in examples 1 to 3 of the present disclosure is found as having improved ZT performance due to the effectively reduced lattice thermal conductivity. Furthermore, it can be seen that portions of the added InSb system material substitute the BTS material and affect the charge concentration, electrical conductivity, and Seebeck coefficient. With the addition of InSb, there is no significant degradation in electrical conductivity and Seebeck coefficient.

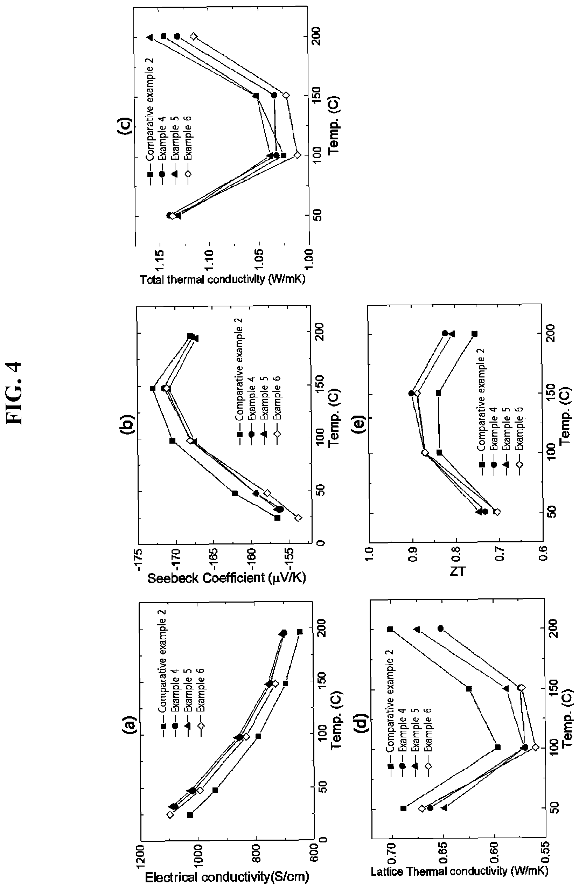

FIG. 4 shows the case in which the matrix is an n-type Bi-Te material containing 0.3 wt% of Cu added (Cu-$Bi_2Te_{2.68}Se_{0.32}$). As compared to comparative example 2, the material containing added InSb or InSb:Se as in examples 4 to 6 of the present disclosure is found as having improved ZT performance due to the effectively reduced lattice thermal conductivity. Furthermore, it can be seen that portions of the added InSb system material substitute the Cu-BTS material and affect the charge concentration, electrical conductivity, and Seebeck coefficient. With the addition of InSb, the electrical conductivity increased and the Seebeck coefficient reduced a bit.

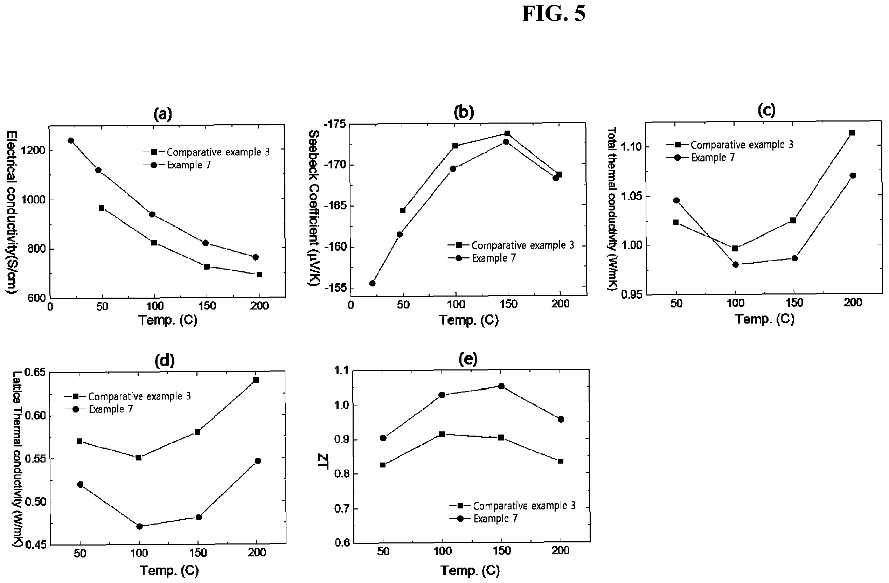

FIG. 5 shows the case in which the matrix is an n-type Bi-Te material containing 0.3 wt% of Cu and 0.3 wt% of Zn added (Cu/Zn-$Bi_2Te_{2.68}Se_{0.32}$). As compared to comparative example 3, the material containing added InSb as in example 7 of the present disclosure is found as having improved ZT performance due to the effectively reduced lattice thermal conductivity. Furthermore, it can be seen that portions of the added InSb substitute the Cu/Zn-BTS material and affect the charge concentration, electrical conductivity, and Seebeck coefficient. With the addition of InSb, the electrical conductivity increased and the Seebeck coefficient reduced a bit.

Upon review of the ZT value of each sample with reference to the results of FIGS. 3 to 5, it can be seen that the compound semiconductors according to many examples of the present disclosure have a higher ZT value than the compound semiconductor of comparative example in the temperature range of between 50 °C and 200 °C . Further, the compound semiconductors according to each example of the present disclosure show a higher ZT value than the compound semiconductor of comparative example over the entire temperature measurement range. Accordingly, it can be seen that when a thermoelectric cooler is made using the compound semiconductors according to examples of the present disclosure, the thermoelectric cooler can have high cooling efficiency.

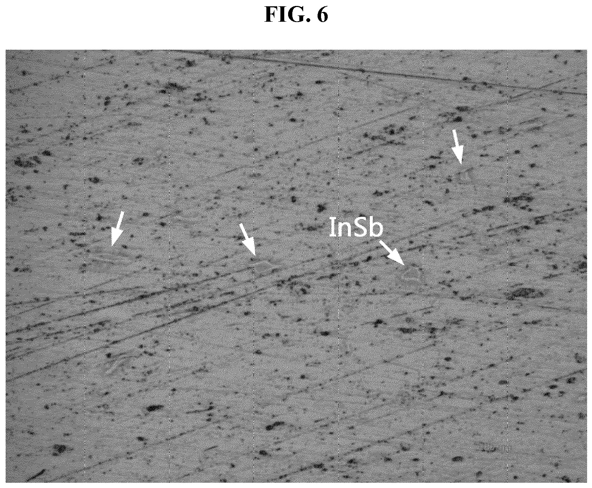

FIGS. 6 to 8 are photographic images showing the microstructure of the compound semiconductor thermoelectric material according to many examples of the present disclosure.

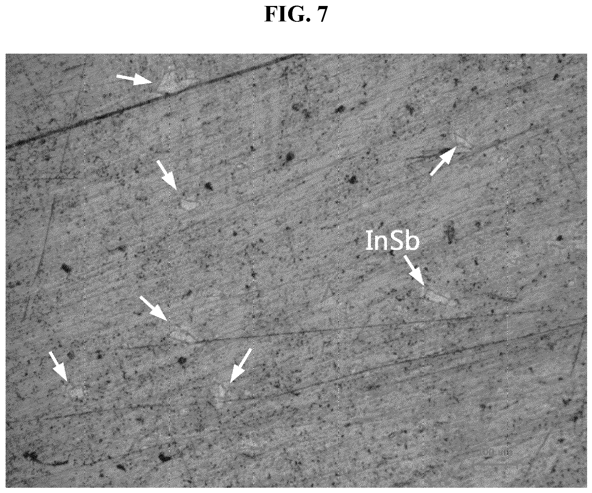

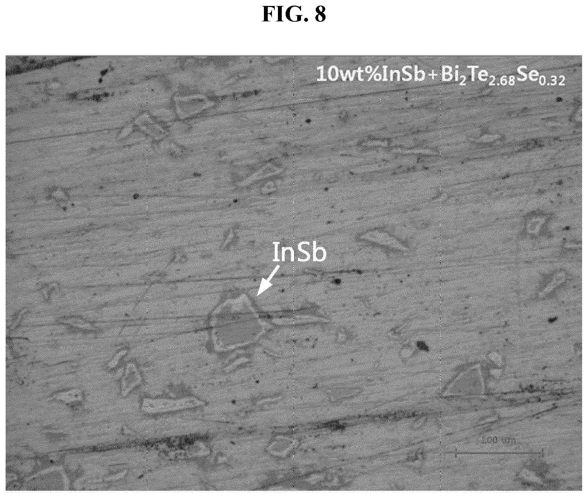

FIG. 6 shows the optical microscope microstructure of example 7, and FIGS. 7 and 8 show the optical microscope microstructure when InSb is added in excess to observe InSb better (FIG. 7 shows the case in which InSb is added in an amount of 3 wt%, and FIG. 8 shows the case in which InSb is added in an amount of 10 wt%).

In FIGS. 6 to 8, arrows indicate the secondary phase InSb in the $Bi_2Te_{2.68}Se_{0.32}$ matrix. SEM-EDS reveals that composition of the secondary phase is InSb. In FIG. 8, it is easier to observe the secondary phase.

As shown in FIGS. 6 to 8, as a result of identifying the microstructure, it can be seen that InSb is dispersed with a nearly similar size to the initial powder particle size in the Bi-Te-Sb system matrix.

Putting together the results collected so far, it can be seen that the compound semiconductor thermoelectric material according to the present disclosure is configured such that $\mu$m scale n-type particles different from the matrix are included in the matrix made of an n-type material, for example, a Bi-Te-Se system material. Furthermore, the n-type particles cause phonon scattering, and reduce the thermal conductivity and improve the ZT value. That is, in the case of the compound semiconductor thermoelectric material according to the present disclosure, the ZT value can be remarkably improved when compared to the compound semiconductor thermoelectric material of comparative example. Therefore, the compound semiconductor thermoelectric material according to an aspect of the present disclosure has excellent thermoelectric performance, and thus, can be usefully used as thermoelectric materials that will be applied to high output thermoelectric power generators and high efficiency thermoelectric coolers.

## Claims

1. A compound semiconductor thermoelectric material (100) comprising:

   an n-type compound semiconductor matrix (110); and
   n-type particles (120) dispersed in the matrix (110), wherein the n-type particles (120) are a compound semiconductor different from the matrix (110), and have an average particle size of 1 $\mu$m to 100 $\mu$m, wherein the matrix (110) is Bi-Te system or Bi-Te-Se system, and wherein the n-type particles (120) are InSb or InSb:Se.

2. The compound semiconductor thermoelectric material (100) according to claim 1, wherein the n-type particles (120) are present in an amount of between 0.1 wt% and 1.0 wt% per the total weight of the compound semiconductor thermoelectric material (100).

3. The compound semiconductor thermoelectric material (100) according to claim 1, wherein the n-type particles (120) are disposed in a grain boundary or grains of the matrix (110).

4. The compound semiconductor thermoelectric material (100) according to claim 1, wherein the n-type particles (120) exist as a stable secondary phase in the matrix (110).

5. The compound semiconductor thermoelectric material (100) according to claim 1, wherein the matrix (110) further includes at least one of Cu, Zn and I.

6. The compound semiconductor thermoelectric material (100) according to claim 1, wherein the n-type particles (120) induce electrical conductivity improvement by modulation doping, or Seebeck coefficient improvement by majority carrier filtering, or bipolar thermal conductivity reduction by minor carrier filtering.

7. A method for manufacturing a compound semiconductor thermoelectric material (100) according to claim 1, the method comprising:

   preparing an n-type compound semiconductor matrix raw material;
   adding n-type particles to the n-type compound semiconductor matrix raw material, wherein the n-type particles (120) are a compound semiconductor different from the matrix (110) and have an average particle size of between 1 $\mu$m and 100 $\mu$m; and
   pressure sintering.

8. The method for manufacturing a compound semiconductor thermoelectric material (100) according to claim 7, wherein the preparing of the n-type compound semiconductor matrix raw material comprises:

forming a mixture including Bi, Te and Se; and
thermally treating the mixture to form a synthesized product.

9. The method for manufacturing a compound semiconductor thermoelectric material (100) according to claim 8, wherein the forming of the synthesized product is performed by a solid phase reaction process.

10. The method for manufacturing a compound semiconductor thermoelectric material (100) according to claim 7, wherein the adding of the n-type particles (120) is performed by a process that adds the n-type particles (120) in powder form to the raw material in powder form.

11. The method for manufacturing a compound semiconductor thermoelectric material according to claim 7, wherein the pressure sintering is performed by a spark plasma sintering process.

**Patentansprüche**

1. Thermoelektrisches Halbleiterverbindungsmaterial (100), umfassend:

eine Halbleitermatrix einer n-Typ-Verbindung (110); und
n-Typ-Partikel (120), dispergiert in der Matrix (110), worin die n-Typ-Partikel (120) eine Halbleiterverbindung sind, die sich von der Matrix (110) unterscheidet und eine mittlere Partikelgröße von 1 $\mu$m bis 100 $\mu$m aufweisen, worin die Matrix (110) vom Bi-Te-System oder Bi-Te-Se-System ist und worin die n-Typ-Partikel (120) InSb oder InSb:Se sind.

2. Thermoelektrisches Halbleiterverbindungsmaterial (100) gemäß Anspruch 1, worin die n-Typ-Partikel (120) in einer Menge von zwischen 0,1 Gew.-% und 1,0 Gew.-% vorliegen, bezogen auf das Gesamtgewicht des thermoelektrischen Halbleiterverbindungsmaterials (100).

3. Thermoelektrisches Halbleiterverbindungsmaterial (100) gemäß Anspruch 1, worin die n-Typ-Partikel (120) an einer Korngrenze oder Körnern der Matrix (110) angeordnet sind.

4. Thermoelektrisches Halbleiterverbindungsmaterial (100) gemäß Anspruch 1, worin die n-Typ-Partikel (120) als eine stabile Sekundärphase in der Matrix (110) vorliegen.

5. Thermoelektrisches Halbleiterverbindungsmaterial (100) gemäß Anspruch 1, worin die Matrix (110) ferner zumindest eines von Cu, Zn und I umfasst.

6. Thermoelektrisches Halbleiterverbindungsmaterial (100) gemäß Anspruch 1, worin die n-Typ-Partikel (120) eine Verbesserung der elektrischen Leitfähigkeit durch Modulationsdotieren oder eine Verbesserung des Seebeck-Koeffizienten durch Hauptträgerfilterung oder eine Verringerung der bipolaren thermischen Leitfähigkeit durch Nebenträgerfilterung induzieren.

7. Verfahren zur Herstellung eines thermoelektrischen Halbleiterverbindungsmaterials (100) gemäß Anspruch 1, wobei das Verfahren umfasst:

Zubereiten eines n-Typ-Halbleiterverbindungsmatrix-Ausgangsmaterials;
Zugeben von n-Typ-Partikeln zu dem n-Typ-Halbleiterverbindungsmatrix-Ausgangsmaterial, worin die n-Typ-Partikel (120) eine Halbleiterverbindung sind, die sich von der Matrix (110) unterscheidet und eine mittlere Partikelgröße von zwischen 1 $\mu$m und 100 $\mu$m aufweisen; und
Drucksintern.

8. Verfahren zur Herstellung eines thermoelektrischen Halbleiterverbindungsmaterials (100) gemäß Anspruch 7, worin das Zubereiten des n-Typ-Halbleiterverbindungsmatrix-Ausgangsmaterials umfasst:

Bilden einer Mischung, enthaltend Bi, Te und Se; und
thermisches Behandeln der Mischung, um ein synthetisiertes Produkt herzustellen.

9. Verfahren zur Herstellung eines thermoelektrischen Halbleiterverbindungsmaterials (100) gemäß Anspruch 8, worin das Bilden des synthetisierten Produkts durch einen Festphasen-Reaktionsprozess durchgeführt wird.

10. Verfahren zur Herstellung eines thermoelektrischen Halbleiterverbindungsmaterials (100) gemäß Anspruch 7, worin das Zugeben der n-Typ-Partikel (120) durch einen Prozess durchgeführt wird, der die n-Typ-Partikel (120) in Pulverform zu dem Ausgangsmaterial in Pulverform zufügt.

11. Verfahren zur Herstellung eines thermoelektrischen Halbleiterverbindungsmaterials gemäß Anspruch 7, worin das Drucksintern durch einen Entladungsplasma-Sinterprozess durchgeführt wird.

**Revendications**

1. Matériau thermoélectrique à semi-conducteur composé (100) comprenant :

   une matrice de semi-conducteur composé de type n (110) ; et
   des particules de type n (120) dispersées dans la matrice (110), dans lequel les particules de type n (120) sont un semi-conducteur composé différent de la matrice (110), et ont une taille moyenne de particule de 1 $\mu$m à 100 $\mu$m, dans lequel la matrice (110) est un système Bi-Te ou un système Bi-Te-Se, et dans lequel les particules de type n (120) sont InSb ou InSb : Se.

2. Matériau thermoélectrique semi-conducteur composé (100) selon la revendication 1, dans lequel les particules de type n (120) sont présentes en une quantité comprise entre 0,1 % en poids et 1,0 % en poids par rapport au poids total du matériau thermoélectrique à semi-conducteur composé (100).

3. Matériau thermoélectrique à semi-conducteur composé (100) selon la revendication 1, dans lequel les particules de type n (120) sont disposées dans une frontière de grain ou des grains de la matrice (110).

4. Matériau thermoélectrique à semi-conducteur composé (100) selon la revendication 1, dans lequel les particules de type n (120) existent en tant que phase secondaire stable dans la matrice (110).

5. Matériau thermoélectrique à semi-conducteur composé (100) selon la revendication 1, dans lequel la matrice (110) inclut en outre au moins un parmi Cu, Zn et 1.

6. Matériau thermoélectrique à semi-conducteur composé (100) selon la revendication 1, dans lequel les particules de type n (120) induisent une amélioration de conductivité électrique par dopage par modulation, ou une amélioration de coefficient de Seebeck par filtrage de porteurs majoritaires, ou une réduction de conductivité thermique bipolaire par filtrage de porteurs mineurs.

7. Procédé de fabrication d'un matériau thermoélectrique à semi-conducteur composé (100) selon la revendication 1, le procédé comprenant les étapes consistant à :

   préparer une matière première de matrice de semi-conducteur composé de type n ;
   ajouter des particules de type n à la matière première de la matrice de semi-conducteur composé de type n, dans lequel les particules de type n (120) sont un semi-conducteur composé différent de la matrice (110) et ont une taille moyenne de particule comprise entre 1 $\mu$m et 100 $\mu$m ; et
   fritter sous pression.

8. Procédé de fabrication d'un matériau thermoélectrique à semi-conducteur composé (100) selon la revendication 7, dans lequel la préparation de la matière première de matrice de semi-conducteur composé de type n comprend les étapes consistant à :

   former un mélange incluant Bi, Te et Se ; et
   traiter thermiquement le mélange pour former un produit synthétisé.

9. Procédé de fabrication d'un matériau thermoélectrique semi-conducteur composé (100) selon la revendication 8, dans lequel la formation du produit synthétisé est effectuée par un processus de réaction en phase solide.

10. Procédé de fabrication d'un matériau thermoélectrique semi-conducteur composé (100) selon la revendication 7, dans lequel l'addition des particules de type n (120) est effectuée par un processus qui ajoute les particules de type n (120) sous forme de poudre à la matière brute sous forme de poudre.

11. Procédé de fabrication d'un matériau thermoélectrique à semi-conducteur composé selon la revendication 7, dans lequel le frittage sous pression est effectué par un processus de frittage par plasma par étincelage.

**FIG. 1**

**FIG. 2**

```
┌─────────────────────────────────────────────┐
│   Prepare n-type compound semiconductor      │
│              matrix raw material             │
│   ─────────────────────────────────────      │  ─S1
│            Form mixture(S1_1)                 │
│                    ↓                          │
│       Form synthesized product(S1_2)          │
└─────────────────────────────────────────────┘
                    ↓
┌─────────────────────────────────────────────┐
│     Add n-type particles different from matrix│  ─S2
└─────────────────────────────────────────────┘
                    ↓
┌─────────────────────────────────────────────┐
│            Sinter under pressure              │  ─S3
└─────────────────────────────────────────────┘
```

FIG. 3

**FIG. 4**

FIG. 5

FIG. 6

**FIG. 7**

FIG. 8

**EP 3 246 959 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 101405318 B1
- US 6225548 B1